(19) **Europäisches Patentamt** / **European Patent Office** / **Office européen des brevets**

(11) **EP 4 588 593 A1**

(12) **EUROPEAN PATENT APPLICATION**

(43) Date of publication:
23.07.2025 Bulletin 2025/30

(21) Application number: 25152395.7

(22) Date of filing: 17.01.2025

(51) International Patent Classification (IPC):
*B22F 1/054* (2022.01)    *B22F 1/0545* (2022.01)
*B22F 1/102* (2022.01)    *B22F 1/107* (2022.01)
*B22F 7/04* (2006.01)    *B23K 35/02* (2006.01)
*B23K 35/30* (2006.01)    *C22C 1/04* (2023.01)
*C22C 9/00* (2006.01)    *H01L 23/00* (2006.01)

(52) Cooperative Patent Classification (CPC):
**B22F 1/0545; B22F 1/056; B22F 1/102;
B22F 1/107; B22F 7/04; B23K 35/025;
B23K 35/302; C22C 1/0425; H01L 24/27;
H01L 24/29; H01L 24/32; H01L 24/83;** B22F 1/05;
B22F 2007/042; H01L 2224/04026;    (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **18.01.2024   JP 2024006164**

(71) Applicant: **Mitsubishi Materials Corporation
Tokyo 100-8117 (JP)**

(72) Inventors:
• IWATA, Kotaro
  Ibaraki 311-0102 (JP)
• TSUCHIYA, Shingo
  Ibaraki 311-0102 (JP)
• NAKAYA, Kiyotaka
  Ibaraki 311-0102 (JP)

(74) Representative: **Gille Hrabal
Partnerschaftsgesellschaft mbB
Patentanwälte
Brucknerstraße 20
40593 Düsseldorf (DE)**

(54) **BONDING PASTE, AND METHOD FOR PRODUCING BONDED BODY**

(57)    A bonding paste is appropriately applied to a member.

A bonding paste 10 includes a bonding paste containing copper particles 12, a solvent 14, and an additive 16, in which a viscosity change rate between one day after and thirty days after the bonding paste 10 is produced is 20% or less.

## FIG.1

EP 4 588 593 A1

**(Cont. next page)**

(52) Cooperative Patent Classification (CPC): (Cont.)
H01L 2224/2929; H01L 2224/29294;
H01L 2224/29339; H01L 2224/29347;
H01L 2224/32225; H01L 2224/32245;
H01L 2224/8384; H01L 2924/00012;
H01L 2924/00014; H01L 2924/013

**Description**

Field

The present invention relates to a bonding paste, and a method for producing a bonded body.

Background

Bonding materials may be used to bond two or more components to each other. In recent years, it has been studied to use a paste containing copper particles as a bonding material. It is described in Patent Literature 1 that a copper paste applied between a first member and a second member is sintered to bond the first member and the second member to each other.

Citation List

Patent Literature

Patent Literature 1: JP 2020-45514 A

Summary

Technical Problem

Here, in order to appropriately bond members to each other, it is required to appropriately apply a bonding paste to the members.
The present invention has been made in view of the above circumstance, and an object of the present invention is to provide a bonding paste that can be appropriately applied to a member, and a method for producing a bonded body.

Solution to Problem

The bonding paste of the present disclosure comprises copper particles; a solvent; and an additive, wherein a viscosity change rate between one day after and thirty days after the bonding paste is produced is 20% or less.
It is preferable that the additive is a phosphate ester.
It is preferable that the additive has an average molecular weight of 500 or more and 1,400 or less.
It is preferable that the additive has a content of 0.1% or more and 10% or less in terms of a mass ratio with respect to a total of the bonding paste.
It is preferable that the solvent is a terpineol solvent.
It is preferable that the solvent has an average molecular weight of 100 or more and 200 or less.
The method for producing a bonded body comprises: bonding a first member and a second member to each other by using the bonding paste as a bonding layer to produce a bonded body.

Advantageous Effects of Invention

According to the present invention, it is possible to obtain a bonding paste that can be appropriately applied to a member, and a method for producing a bonded body.

Brief Description of Drawings

    FIG. 1 is a schematic diagram illustrating a bonding paste according to the present embodiment.
    FIG. 2 is a schematic diagram illustrating a bonded body according to the present embodiment.
    FIG. 3 is a table illustrating a bonding paste of each of examples.

Description of Embodiments

Hereinafter, the present invention will be described in detail with reference to the drawings. Note that the present invention is not limited by the following embodiment of description (hereinafter, referred to as the embodiment). In addition, constituent elements in the following embodiments include those that can be easily assumed by those skilled in the art, those that are substantially the same, and those within a so-called equivalent range. Furthermore, the components disclosed in the following embodiments can be appropriately combined. The numerical values include a range of rounding.

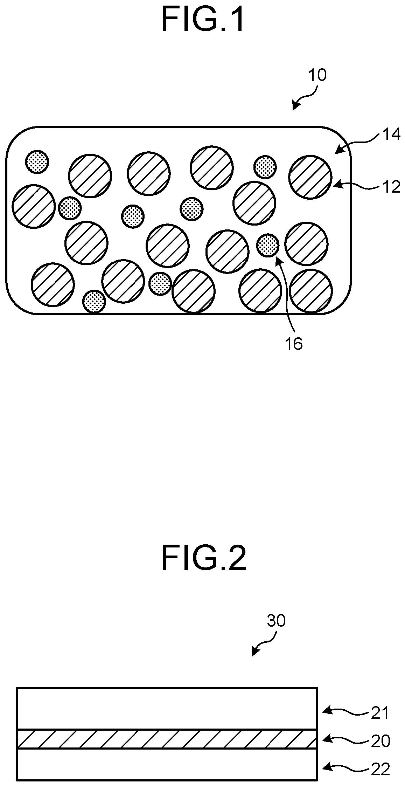

FIG. 1 is a schematic diagram illustrating a bonding paste according to the present embodiment. The bonding paste of the present embodiment is used to bond members to each other. As illustrated in FIG. 1, a bonding paste 10 of the present embodiment contains copper particles 12, a solvent 14, and an additive 16. Note that FIG. 1 is a schematic diagram, and the actual shape of the bonding paste 10 is not limited to that in FIG. 1.

(Copper Particles)

The copper particles 12 preferably have a BET diameter of 50 nm or more and 300 nm or less. The BET diameter is a particle diameter calculated using the BET specific surface area and the true density of the copper particles obtained by the BET method with the copper particles 12 regarded as a true sphere. Specifically, it can be obtained by a method described in examples described later.

In a case where the BET diameter of the copper particles 12 is 50 nm or more, it is difficult to form robust aggregates. Therefore, the surfaces of the copper particles 12 can be uniformly coated with the solvent 14. On the other hand, in a case where the BET diameter of the copper particles 12 is 300 nm or less, the reaction area is large, and sinterability by heating is increased, so that a robust bonding layer can be formed. The BET diameter of the copper particles 12 is preferably within a range of 80 nm or more and 200 nm or less, and particularly preferably within a range of 80 nm or more and 170 nm or less.

The BET specific surface area of the copper particles 12 is preferably within a range of 2.0 $m^2$/g or more and 8.0 $m^2$/g or less, more preferably within a range of 3.5 $m^2$/g or more and 8.0 $m^2$/g or less, and particularly preferably within a range of 4.0 $m^2$/g or more and 8.0 $m^2$/g or less. In addition, the shape of the copper particles 12 is not limited to a spherical shape, and may also be a needle shape or a flat plate shape.

The surfaces of the copper particles 12 are preferably coated with an organic protective film that is an organic film. Since the organic protective film is coated, oxidation of the copper particles 12 is minimized, and deterioration of sinterability due to the oxidation of the copper particles 12 is further less likely to occur. It can be said that the organic protective film with which the copper particles 12 are coated is not formed by the solvent 14 and is not derived from the solvent 14. It can also be said that the organic protective film with which the copper particles 12 are coated does not include a copper oxide film formed by oxidation of copper.

The fact that the copper particles 12 are coated with the organic protective film can be confirmed by analyzing the surfaces of the copper particles 12 with time-of-flight secondary ion mass spectrometry (TOF-SIMS). Therefore, in the present embodiment, the copper particles 12 preferably have a ratio of the amount of $C_3H_3O_3^-$ ions detected to the amount of $Cu^+$ ions detected ($C_3H_3O_3^-$/$Cu^+$ ratio) of 0.001 or more, the detections being obtained by surface analysis with the time-of-flight secondary ion mass spectrometry. The $C_3H_3O_3^-$/$Cu^+$ ratio is still more preferably within a range of 0.05 or more and 0.2 or less. The surfaces of the copper particles 12 in this analysis refers not to the surfaces of the copper particles 12 with the organic protective film removed from the copper particles 12, but to the surfaces of the copper particles 12 containing the organic protective film with which the copper particles 12 are coated (that is, the surface of the organic protective film).

In the copper particles 12, $C_3H_4O_2^-$ ions or $C_5$ or higher ions may be detected by surface analysis with the time-of-flight secondary ion mass spectrometry. A ratio of the amount of $C_3H_4O_2^+$ ions detected to the amount of $Cu^+$ ions detected ($C_3H_4O_2^+$/$Cu^+$ ratio) is preferably 0.001 or more. In addition, a ratio of the amount of $C_5$ or higher ions detected to the amount of $Cu^+$ ions detected ($C_5$ or higher ions/$Cu^+$ ratio) is preferably less than 0.005.

The $C_3H_3O_3^-$ ions, $C_3H_4O_2^-$, and $C_5$ or higher ions detected with the time-of-flight secondary ion mass spectrometry are derived from the organic protective film with which the surfaces of the copper particles 12 are coated. Therefore, in a case where each of the $C_3H_3O_3^-$/$Cu^+$ ratio and the $C_3H_4O_2^-$/$Cu^+$ ratio is 0.001 or more, the surfaces of the copper particles 12 are less likely to be oxidized, and the copper particles 12 are less likely to aggregate. In addition, in a case where the $C_3H_3O_3^-$/$Cu^+$ ratio and the $C_3H_4O_2^-$/$Cu^+$ ratio are 0.2 or less, oxidation and aggregation of the copper particles 12 can be mitigated without excessively lowering the sinterability of the copper particles 12, and the generation of a decomposition gas of the organic protective film during the heating can be further reduced, leading to the formation of a bonding layer having few voids. In order to further improve the oxidation resistance during the storage of the copper particles 12 and further improve the sinterability at a low temperature, the $C_3H_3O_3^-$/$Cu^+$ ratio and the $C_3H_4O_2^-$/$Cu^+$ ratio are preferably within a range of 0.08 or more and 0.16 or less. In addition, in a case where the $C_5$ or higher ions/$Cu^+$ ratio is 0.005 times or more, an organic protective film having a relatively high desorption temperature is predominantly present on the surfaces of the particles; as a result, the sinterability is not sufficiently exhibited, and a robust bonding layer is less likely to be obtained. The $C_5$ or higher ions/$Cu^+$ ratio is preferably less than 0.003 times.

The organic protective film is preferably derived from citric acid. A method for producing the copper particles 12 coated with an organic protective film derived from citric acid will be described later. The coating amount of the organic protective film on the copper particles 12 is preferably within a range of 0.5% by mass or more and 2.0% by mass or less, more preferably within a range of 0.8% by mass or more and 1.8% by mass or less, and still more preferably within a range of 0.8% by mass or more and 1.5% by mass or less with respect to 100% by mass of the copper particles. In a case where the coating amount of the organic protective film is set to 0.5% by mass or more, the copper particles 12 can be uniformly coated with the organic protective film, and oxidation of the copper particles 12 can be more reliably mitigated. In addition, in a case where the coating amount of the organic protective film is set to 2.0% by mass or less, it is possible to minimize voids generated due to the gas generated by decomposition of the organic protective film by heating in a sintered body (bonding layer) containing copper particles. The coating amount of the organic protective film can be measured by using a commercially available apparatus. For example, the coating amount can be measured by using the thermogravimetry-differential thermal analysis TG8120 SL (manufactured by Rigaku Holdings Corporation). In this case, for example, copper particles from which moisture has been removed by freeze drying are used as a sample. When the measurement is carried out in nitrogen (G2 grade) gas in order to mitigate oxidation of the copper particles, and the temperature is increased at a rate of 10°C/min from 250°C to 300°C, the weight reduction rate can be defined as the coating amount of the organic protective film. That is, the coating amount = (sample weight after measurement)/(sample weight before measurement) × 100 (% by weight). The measurement may be conducted three times using copper particles from the same lot, and the arithmetic mean value may be used as the coating amount.

When the copper particles 12 are heated at a temperature of 300°C for 30 minutes under an inert gas atmosphere such as argon gas, 50% by mass or more of the organic protective film is preferably decomposed. The organic protective film derived from citric acid generates carbon dioxide gas, nitrogen gas, evaporation gas of acetone, and water vapor during decomposition.

The copper particles 12 coated with the organic protective film derived from citric acid can be produced, for example, as follows. First, an aqueous copper citrate dispersion is prepared, and a pH adjusting agent is added to this aqueous copper citrate dispersion to adjust the pH to 2.0 or more and 7.5 or less. To the aqueous copper citrate dispersion whose pH has been adjusted under an inert gas atmosphere is then added and mixed 1.0 times equivalents or more and 1.2 times equivalents or less of a hydrazine compound capable of reducing copper ions as a reducing agent. For the obtained mixed solution, the obtained mixed solution is heated to a temperature of 60°C or higher and 80°C or lower under an inert gas atmosphere, and held for 1.5 hours or more and 2.5 hours or less. As a result, copper ions eluted from copper citrate are reduced, leading to the formation of the copper particles 12, and an organic protective film derived from citric acid is formed on the surfaces of the copper particles 12.

The aqueous copper citrate dispersion can be prepared by adding powdered copper citrate to pure water such as distilled water or ion-exchanged water to have a concentration of 25% by mass or more and 40% by mass or less, stirring the mixture with a stirring blade, and uniformly dispersing the mixture. Examples of the pH adjusting agent include triammonium citrate, ammonium hydrogen citrate, citric acid, and other pH adjusting agents. Among these, triammonium citrate is preferable because it is easy to adjust the pH mildly. The reason why the pH of the aqueous copper citrate dispersion is set to 2.0 or higher is to increase the elution rate of copper ions eluted from copper citrate, allowing the formation of copper particles to progress rapidly, thereby obtaining the desired fine copper particles 12. In addition, the reason why the pH is set to 7.5 or lower is to inhibit the eluted copper ions from becoming copper(II) hydroxide, thereby increasing the yield of the copper particles 12. Furthermore, it is possible to inhibit an excessive increase in the reducing power of the hydrazine compound by setting the pH to 7.5 or lower, so that the desired copper particles 12 are easily obtained. The pH of the aqueous copper citrate dispersion is preferably adjusted within a range of 4 or higher and 6 or lower.

The reduction of copper citrate by the hydrazine compound is carried out under an inert gas atmosphere. This is to prevent oxidation of copper ions eluted into a solution. Examples of the inert gas include nitrogen gas, argon gas, and other inert gases. The hydrazine compound has positive aspects that no residue is generated after the reduction reaction when copper citrate is reduced under acidity, safety is relatively high, and handling is easy. Examples of this hydrazine compound include hydrazine monohydrate, anhydrous hydrazine, hydrazine hydrochloride, hydrazine sulfate, and other similar substances. Among these hydrazine compounds, hydrazine monohydrate and anhydrous hydrazine, which do not contain components such as sulfur and chlorine that can be impurities, are preferable.

In general, copper produced in an acidic solution having a pH of less than 7 dissolves. However, in the present embodiment, a hydrazine compound serving as a reducing agent is added to and mixed with the acidic solution having a pH of less than 7 to form the copper particles 12 in the resulting mixed solution. Therefore, the surfaces of the copper particles 12 are rapidly coated with a component derived from citric acid produced from copper citrate, resulting in inhibition of the dissolution of the copper particles 12. For the aqueous copper citrate dispersion after the pH is adjusted, it is preferable to set a temperature of 50°C or higher and 70°C or lower to facilitate the reduction reaction.

The reason why the mixed solution in which the hydrazine compound is mixed is heated to a temperature of 60°C or higher and 80°C or lower under an inert gas atmosphere and is held for 1.5 hours or more and 2.5 hours or less is to form the copper particles 12 and to form an organic protective film on the surfaces of the formed copper particles 12, thereby achieve coating with the organic protective film. The heating and holding under the inert gas atmosphere is to prevent oxidation of the formed copper particles 12. Copper citrate as a starting material usually contains a copper component in an amount of about 35% by mass. By adding the hydrazine compound serving as a reducing agent to the aqueous copper citrate dispersion containing the copper component at this level, temperature-increasing heating the mixture at the above-described temperature, and holding the mixture for the above-described time, the formation of the copper particles 12 and the formation of the organic protective film on the surfaces of the copper particles 12 proceed in a well-balanced manner. Thus, it is possible to obtain the copper particles 12 containing the organic protective film in a coating amount within a range of 0.5% by mass or more and 2.0% by mass or less with respect to 100% by mass of the copper particles. In a case where the heating temperature is lower than 60°C, and the holding time is less than 1.5 hours, copper citrate is not completely reduced, the formation rate of the copper particles 12 is excessively slow, resulting in the risk that the amount of the organic protective film with which the copper particles 12 are coated may be excessive. In addition, in a case where the heating temperature is higher than 80°C, and the holding time is more than 2.5 hours, the formation rate of the copper particles 12 is excessively fast, resulting in the risk that the amount of the organic protective film with which the copper particles 12 are coated may be excessively small. The heating temperature is preferably 65°C or higher and 75°C or lower, and the holding time is preferably 2 hours or more and 2.5 hours or less.

The copper particles 12 formed in the mixed solution are subjected to solid-liquid separation from the mixed solution under an inert gas atmosphere by using, for example, a centrifuge, and are dried by a freeze-drying method or a reduced-pressure drying method to obtain the copper particles 12 of which the surfaces are coated with the organic protective film. Since the surfaces of these copper particles 12 are coated with the organic protective film, oxidation is unlikely to occur even though the copper particles 12 are stored in the atmosphere until being used as the bonding paste 10.

(Solvent)

The solvent 14 acts as a binder for the copper particles 12. The solvent 14 is an organic solvent. As the solvent 14, any solvent may be used, and examples thereof include at least one of an alcohol solvent, a glycol- solvent, an acetate solvent, a hydrocarbon solvent, or an amine solvent. Furthermore, the solvent 14 is preferably an alcohol solvent, and more preferably a terpineol solvent. Examples of the terpineol solvent used for the solvent 14 include at least one of dihydroterpineol, $\alpha$-terpineol, or menthol, and dihydroterpineol is particularly preferable. As the alcohol solvent, isopropyl alcohol may be used.

In addition, specific examples of the glycol solvent include ethylene glycol, diethylene glycol, and polyethylene glycol. Specific examples of the acetate solvent include butyl acetate carbitate. Specific examples of the hydrocarbon solvent include decane, dodecane, and tetradecane. Specific examples of the amine solvent include hexylamine, octylamine, and dodecylamine.

The solvent 14 preferably has an average molecular weight of 100 or more and 200 or less. By setting the average molecular weight of the solvent 14 within this range, the viscosity change rate after the production of the bonding paste 10 can be reduced, and the bonding paste 10 can be appropriately applied to a member without excessively increasing the viscosity even after a lapse of time. The average molecular weight herein refers to a weight-average molecular weight. The average molecular weight can be measured, for example, by size exclusion chromatography.

(Additive)

The additive 16 includes an additive to be added to the bonding paste 10. The additive 16 may have, for example, at least one function of reducing the viscosity change rate after the production of the bonding paste 10 or inhibiting oxidation of the copper particles 12.

The additive 16 may be any substance, but is preferably a phosphate ester. Among organic phosphoric acid compounds, an ester obtained by dehydration condensation of phosphoric acid and alcohol may be referred to as a phosphate ester.

The phosphate ester used for the additive 16 may be any phosphate ester, and examples thereof include laureth-n phosphate, oleth-n phosphate, steareth-n phosphate (n is an integer), polyoxyethylene tridecyl ether phosphate, polyoxyethylene oleyl ether phosphate, and other phosphate esters. As the additive 16, one of these may be used, or two or more thereof may be used. As the additive 16, it is preferable to use a phosphate ester other than polyoxyethylene (10) ether phosphate.

As the additive 16, it is more preferable to use at least one of polyoxyethylene tridecyl ether phosphate or polyoxyethylene oleyl ether phosphate.

By using such materials as the additive 16, the viscosity change rate after the production of the bonding paste 10 can be reduced, and the bonding paste 10 can be appropriately applied to a member. In addition, oxidation of the copper particles 12 can also be inhibited by using a phosphate ester as the additive 16.

The additive 16 preferably has an average molecular weight of 500 or more and 1,400 or less, more preferably 800 or more and 1,400 or less, and still more preferably 1,000 or more and 1,400 or less. By setting the average molecular weight of the additive 16 within this range, the viscosity change rate after the production of the bonding paste 10 can be reduced, and the bonding paste 10 can be appropriately applied to a member. The average molecular weight herein refers to a weight-average molecular weight. The average molecular weight can be measured, for example, by size exclusion chromatography.

(Mixing Ratio of Bonding Paste)

In the present embodiment, it is preferable that the bonding paste 10 does not contain substances other than the copper particles 12, the solvent 14, and the additive 16, except for inevitable impurities. However, the present invention is not limited thereto, and the bonding paste 10 may contain additives other than the copper particles 12, the solvent 14, and the additive 16.

In the bonding paste 10, a content of the additive 16 is preferably 0.1% or more and 10% or less, more preferably 0.5% or more and 5% or less, and still more preferably 1% or more and 3% or less in terms of a mass ratio with respect to the total of the bonding paste 10. By setting the content of the additive 16 within this range, the viscosity change rate after the production of the bonding paste 10 can be reduced, and the bonding paste 10 can be appropriately applied to a member.

In the bonding paste 10, a content of the solvent 14 is preferably 1% or more and 20% or less, more preferably 5% or more and 15% or less, and still more preferably 5% or more and 10% or less in terms of a mass ratio with respect to the total of the bonding paste 10. By setting the content of the solvent 14 within this range, the viscosity change rate after the production of the bonding paste 10 can be reduced, and the bonding paste 10 can be appropriately applied to a member.

In the bonding paste 10, a content of the copper particles 12 is preferably 70% or more and 99% or less, more preferably 80% or more and 95% or less, and still more preferably 85% or more and 90% or less in terms of a mass ratio with respect to the total of the bonding paste 10. By setting the content of the copper particles 12 within this range, the members can be appropriately bonded to each other.

(Viscosity Change Rate)

A viscosity change rate $\Delta\eta$ of the bonding paste 10 between one day after and thirty days after the bonding paste 10 is produced is 20% or less, preferably 10% or less, and more preferably 5% or more. The viscosity change rate $\Delta\eta$ is preferably 5% or more and 20% or less, and more preferably 5% or more and 10% or less. By setting the viscosity change rate $\Delta\eta$ within this range, an increase in viscosity over time is minimized, and the bonding paste 10 can be appropriately applied to a member even after a lapse of time from the production.

The viscosity change rate $\Delta\eta$ between one day after and thirty days after the bonding paste 10 is produced is calculated as in the following equation (1).

$$\Delta\eta \ (\%) \ = \ |\eta_{30}-\eta_1|/\eta_1 \ \times \ 100 \qquad\qquad (1)$$

In Equation (1), $\eta_1$ is a viscosity (Pa·s) of the bonding paste 10 after a lapse of one day from the production of the bonding paste 10, and $\eta_{30}$ is a viscosity (Pa·s) of the bonding paste after a lapse of thirty days from the production of the bonding paste 10. In other words, in the present embodiment, the viscosity change rate $\Delta\eta$ refers to a viscosity change rate from one day after to thirty days after the bonding paste 10 is produced.

One day after the bonding paste 10 is produced may refer to a time point at which 23 hours or more and 25 hours or less have elapsed after the bonding paste 10 is stored in the air atmosphere at room temperature (25°C) from the time point at which the copper particles 12, the solvent 14, and the additive 16 are mixed to produce the bonding paste 10.

Thirty days after the bonding paste 10 is produced may refer to a time point at which 719 hours or more and 721 hours or less have elapsed after the bonding paste 10 is stored in the air atmosphere at room temperature (25°C) from the time point at which the copper particles 12, the solvent 14, and the additive 16 are mixed to produce the bonding paste 10.

In addition, the viscosity of the bonding paste 10 refers to a viscosity at 25°C. That is, $\eta_1$ is a viscosity at 25°C of the bonding paste 10 after a lapse of one day from the production, and $\eta_{30}$ is a viscosity at 25°C of the bonding paste 10 after a lapse of thirty days from the production. The viscosity can be measured with a micro spiral viscometer (PCU-02V) manufactured by Malcom Co., Ltd.

As described above, the viscosity change rate $\Delta\eta$ refers to the viscosity change rate between one day after and thirty days after the production, but may refer to a viscosity change rate thirty days after the bonding paste 10 produced is obtained. That is, $\eta_1$ in Equation (1) may be a viscosity after the bonding paste 10 produced is stored at 25°C for one day (for example, 23 hours or more and 25 hours or less), or $\eta_1$ in Equation (1) may be a viscosity after the bonding paste 10 produced is stored at 25°C for thirty days (for example, 719 hours or more and 721 hours or less).

Means for setting the viscosity change rate $\Delta\eta$ within the above-described range may be optional. In other words, for example, even though any type and mixing ratio of the solvent 14 and the additive 16 are employed, the bonding paste 10 can be appropriately applied to a member even after a lapse of time from the production as long as the viscosity change rate $\Delta\eta$ is within the above-described range. However, by setting at least one of the type of the solvent 14, the mixing ratio of the solvent 14, the type of the additive 16, or the mixing ratio of the additive 16 as defined in the present embodiment, the viscosity change rate $\Delta\eta$ can be appropriately set within the above-described range, which is preferable.

The viscosity $\eta_{30}$ may include a value of the viscosity $\eta_1$ or more. The viscosity $\eta_{30}$ is preferably 1 Pa•s or more and 200 Pa•s or less, more preferably 10 Pa•s or more and 200 Pa•s or less, and still more preferably 50 Pa•s or more and 200 Pa•s or less. In addition, the viscosity $\eta_1$ is preferably 1 Pa•s or more and 200 Pa•s or less, more preferably 10 Pa•s or more and 200 Pa•s or less, and still more preferably 50 Pa•s or more and 200 Pa•s or less. By setting the viscosity within this range, the bonding paste 10 can be appropriately applied to the member.

(Method for Producing Bonding Paste)

The bonding paste 10 is produced by carrying out a mixing step of mixing the copper particles 12, the solvent 14, and the additive 16. In this mixing step, the copper particles 12, the solvent 14, and the additive 16 are preferably mixed so that the content of the additive 16, the content of the solvent 14, and the content of the copper particles 12 are within the above-described ranges. In addition, in the mixing step, the copper particles 12, the solvent 14, and the additive 16 may be mixed by using a kneading machine. As the kneading machine, for example, a three roll mill is used.

(Method for Producing Bonded Body)

FIG. 2 is a schematic diagram illustrating a bonded body according to the present embodiment. As illustrated in FIG. 2, in the present embodiment, a bonded body 30 is produced by bonding a first member 21 and a second member 22 to each other using the bonding paste 10 as a bonding layer 20. The first member 21 and the second member 22 may be any members, and for example, one of the first member 21 or a second base material may be a substrate and the other may be an electronic component. That is, a semiconductor module in which a substrate and an electronic component are bonded by the bonding layer 20 may be manufactured as the bonded body 30. The substrate is not particularly limited, and examples thereof include mounting substrates semiconductor elements such as an oxygen-free copper plate, a copper-molybdenum plate, a high heat dissipation insulating substrate (for example, direct copper bond (DCB)), and a light emitting diode (LED) package, and other substrates. Examples of the electronic component include semiconductor devices such as an insulated gate bipolar transistor (IGBT), a diode, a Schottky barrier diode, a metal oxide semiconductor field effect transistor (MOS-FET), a thyristor, a logic, a sensor, an analog integrated circuit, an LED, a semiconductor laser, and a transmitter.

In the present production method, a coating layer-forming step of applying the bonding paste 10 to a surface of at least one of the first member 21 or the second member 22 to form a coating layer is carried out. The application method is not particularly limited, and examples thereof include a spin coating method, a metal mask method, a spray coating method, a dispenser coating method, a knife coating method, a slit coating method, an inkjet coating method, a screen printing method, an offset printing method, and a die coating method. Next, in order to volatilize the solvent in the paste, a preheating step is carried out at a temperature of 50°C to 150°C for 1 minute to 30 minutes. Next, an overlapping step of overlapping the first member 21 and the second member 22 with the coating layer sandwiched therebetween is carried out.

Next, a heating step of heating the first member 21 and the second member 22 overlapped with each other with the coating layer sandwiched therebetween is carried out. In the heating step, heating is performed at a predetermined temperature for a predetermined time while applying a predetermined pressure to at least one of the first member 21 or the second member 22 under a non-reducing atmosphere, with the first member 21 and the second member 22 overlapped with each. By carrying out the heating step, the copper particles 12 in the coating layer are sintered to form the bonding layer 20, and the bonded body 30 in which the first member 21 and the second member 22 are bonded via the bonding layer 20 is manufactured.

The non-reducing atmosphere in the heating step refers to a state filled with a non-reducing gas, and can also be referred to as an inert gas atmosphere filled with an inert gas. Examples of the non-reducing gas include nitrogen and rare gases such as argon. For example, in the present embodiment, the heating step may be carried out under a nitrogen atmosphere having an oxygen concentration of 1,000 ppm. By carrying out the heating step under the non-reducing atmosphere, it is not necessary to use the reducing gas, and the heating step can be easily carried out.

In addition, the predetermined pressure applied to at least one of the first member 21 or the second member 22 is preferably 0.5 MPa or more and 10 MPa or less, more preferably 1 MPa or more and 5 MPa or less, and still more preferably 2 MPa or more and 5 MPa or less. By setting the applied pressure within such a relatively low range, it is possible to minimize the shape defects of the bonding layer 20 while the first member 21 and the second member 22 are appropriately bonded to each other. The pressure here is applied in a direction in which the first member 21 and the second member 22 are relatively pressed against each other with the coating layer sandwiched therebetween.

In addition, the predetermined temperature, which is the heating temperature in the heating step, is preferably 200°C or higher and 300°C or lower, more preferably 230°C or higher and 300°C or lower, and still more preferably 250°C or higher and 300°C or lower. By setting the heating temperature within such a relatively low range, it is possible to minimize the shape defects of the bonding layer 20 while the copper particles 12 are appropriately sintered.

In addition, the predetermined time, which is the heating time in the heating step, is preferably 1 minute or more and 10 minutes or less, more preferably 1 minute or more and 5 minutes or less, and still more preferably 1 minute or more and 3 minutes or less. By setting the heating time within this range, the copper particles 12 can be appropriately sintered.

(Bonding Layer)

As described above, the bonding layer 20 in the present embodiment is formed by heating the bonding paste 10 and sintering the copper particles 12. The bonding layer 20 is positioned between the first member 21 and the second member 22 to bond the first member 21 and the second member 22. The bonding layer 20 can also be referred to as a copper sintered body. The bonding layer 20 preferably has a sintering density of the copper particles of 80% or more, more preferably 85% or more and 95% or less, and still more preferably 85% or more and 90% or less. By setting the sintering density within this range, the bonding layer 20 can ensure conductivity and thermal conductivity. The sintering density refers to a ratio of the volume of the bonding layer 20 excluding open pores and closed pores to the total volume of the bonding layer 20 including the open pores and the closed pores. For sintering density, the sintering density was calculated by binarizing images of the cross section of the bonding layer randomly taken at 30,000x magnification with a scanning electron microscope (SEM) using image processing software (ImageJ manufactured by National Institutes of Health, USA), and dividing the binarization results into particle portions and pore portions to obtain the result by the following equation.

Sintering density (%) = (total area of particle portion/(total area of particle portions + total area of vacancy portions)) × 100

The bonding layer 20 may also contain phosphorus. Here, phosphorus refers to phosphorus as an element, and includes not only simple phosphorus but also phosphorus contained in any compound. In the bonding layer 20, a content of phosphorus is preferably 10 ppm or more and 1,000 ppm or less, more preferably 50 ppm or more and 500 ppm or less, and even more preferably 100 ppm or more and 500 ppm or less in terms of a mass ratio with respect to the entire bonding layer 20. By setting the content of phosphorus within this range, a decrease in strength of the bonding layer 20 is minimized even though the bonding layer is formed under a non-reducing atmosphere, for example. The content of phosphorus can be measured by ICP emission spectrometer (inductivity coupled plasma optical emission spectrometer; ICP-OES). In the present embodiment, phosphorus contained in the bonding layer 20 is derived from a phosphate ester contained in the bonding paste 10.

In addition, the bonding layer 20 preferably has a thickness of 10 $\mu$m or more and 200 $\mu$m or less, more preferably 20 $\mu$m or more and 150 $\mu$m or less, and still more preferably 50 $\mu$m or more and 100 $\mu$m or less. By setting the thickness of the bonding layer 20 within this range, it is possible to maintain high heat dissipation while alleviating stress due to a difference in linear expansion coefficient between the members due to a temperature difference.

As described above, the bonding layer 20 according to the present embodiment includes a copper sintered body having a sintering density of 80% or more and containing phosphorus. Since the bonding layer 20 according to the present embodiment has a sintering density of 80% or more, a decrease in strength is minimized. Furthermore, since oxidation of the copper particles 12 is inhibited by the derivative of phosphorus (phosphate ester in the present embodiment) contained in the bonding layer 20, a decrease in strength of the bonding layer 20 containing phosphorus is, as a result, minimized. Although the bonding layer 20 in the present embodiment is formed by heating the bonding paste 10 as described above, the method for forming the bonding layer 20 may be any method as long as the bonding layer 20 satisfies the above characteristics.

(Effects)

As described above, the bonding paste 10 according to the present embodiment contains the copper particles 12, the solvent 14, and the additive 16, and the viscosity change rate $\Delta\eta$ between one day after and thirty days after the bonding paste 10 is produced is 20% or less. According to the present embodiment, by setting the viscosity change rate $\Delta\eta$ within this range, an increase in viscosity over time is minimized (the viscosity is less likely to increase), and the bonding paste 10 can be appropriately applied to a member even after a lapse of time from the production.

The additive 16 is preferably a phosphate ester. Oxidation of the copper particles 12 can be inhibited by using a phosphate ester as the additive 16.

The additive 16 preferably has an average molecular weight of 500 or more and 1,400 or less. By using an additive having an average molecular weight within this range (preferably, a phosphate ester) as the additive 16, an increase in viscosity over time can be minimized, and the bonding paste 10 can be appropriately applied to a member.

The content of the additive 16 is preferably 0.1% or more and 10% or less in terms of a mass ratio with respect to the total of the bonding paste 10. By setting the content of the additive 16 within this range, an increase in viscosity over time can be minimized, and the bonding paste 10 can be appropriately applied to a member.

The solvent 14 is preferably a terpineol solvent. By using the terpineol solvent as the solvent 14, an increase in viscosity over time can be minimized, and the bonding paste 10 can be appropriately applied to a member.

The solvent 14 preferably has an average molecular weight of 100 or more and 200 or less. By using a solvent having an average molecular weight within this range (preferably, a terpineol solvent) as the solvent 14, an increase in viscosity over time can be minimized, and the bonding paste 10 can be appropriately applied to a member.

According to the method for producing the bonded body of the present embodiment, the bonded body 30 is produced by bonding the first member 21 and the second member 22 to each other using the bonding paste 10 as the bonding layer 20. According to the present embodiment, the bonding paste 10 can be appropriately applied to the first member 21 and the second member 22, and the bonded body 30 can be appropriately produced.

(Examples)

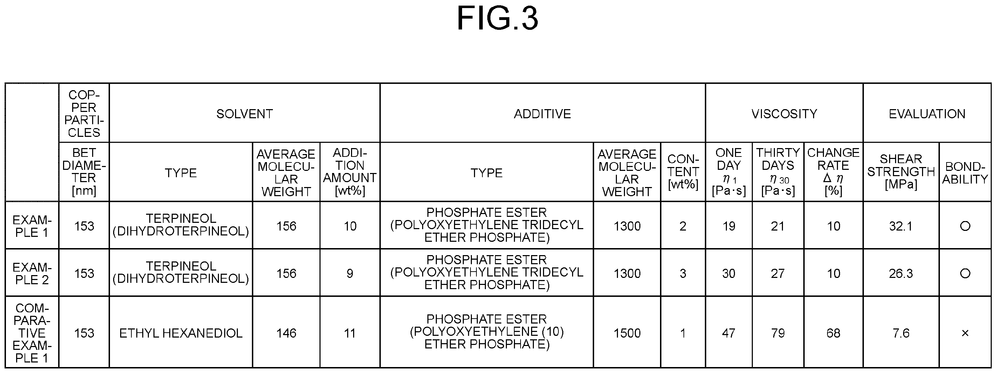

Next, examples will be described. FIG. 3 is a table illustrating a bonding paste of each of examples.

(Example 1)

In Example 1, copper particles having a BET diameter of 153 nm were prepared. For the BET diameter, the amount of nitrogen gas adsorbed to the copper particles was measured using a specific surface area measuring apparatus (QUANTACHROME AUTOSORB-1, manufactured by Quantachrome Instruments, Inc.), and the specific surface area of the copper particles was determined by the BET method. The obtained specific surface area S (m$^2$/g) and the density $\rho$ (g/cm$^3$) of the copper particles were used to calculate the BET diameter by the following equation.

$$\text{BET diameter (nm)} = 6,000/(\rho(\text{g/cm}^3) \times S\ (\text{m}^2/\text{g}))$$

In Example 1, polyoxyethylene tridecyl ether phosphate as a phosphate ester was prepared as an additive, and dihydroterpineol as a terpineol solvent was prepared as a solvent.

In Example 1, the copper particles, the additive, and the solvent were then mixed so that the content of the additive was 2% by mass, the content of the solvent was 10% by mass, and the remaining corresponded to the copper particles to obtain a bonding paste.

The obtained bonding paste was stored in an atmospheric pressure atmosphere at 25°C for one day (24 hours), and a viscosity $\eta_1$ (Pa•s) after a lapse of one day from the production of the bonding paste 10 was measured. In addition, the obtained bonding paste was stored in an atmospheric pressure atmosphere at 25°C for thirty days (720 hours), and a viscosity $\eta_{30}$ (Pa•s) after a lapse of thirty days from the production of the bonding paste 10 was measured. Then, the viscosity change rate $\Delta\eta$ (%) between one day after and thirty days after the production was calculated by using Equation (1) of the above-described embodiment. Note that the viscosity was a viscosity at 25°C and was measured with a micro spiral viscometer (PCU-02V) manufactured by Malcom Co., Ltd. The rotation speed was 10 rpm. These measurement results are illustrated in FIG. 3.

(Example 2 and Comparative Example 1)

In Example 2 and Comparative Example 1, a bonding paste was obtained in the same manner as in Example 1 except that the BET diameter of the copper particles, the type of the additive, the content of the additive, the type of the solvent, and the content of the solvent were changed as illustrated in FIG. 3, and the viscosity $\eta_1$, the viscosity $\eta_{30}$, and the viscosity change rate $\Delta\eta$ (%) were measured. These measurement results are illustrated in FIG. 3.

(Evaluation)

The bondability of the bonding paste obtained in each example was evaluated.

In the evaluation of bondability, a bonded body was produced using the bonding paste (the bonding paste after a lapse of thirty days from the production) obtained in each example. Specifically, an opening of 3 mm was formed on an oxygen-free copper plate, the bonding paste of each example was printed with a metal mask having a thickness of 50 μm and a metal squeegee and was then dried on a hot plate at 90°C for 5 minutes, a silicon dummy chip of 2.5 mm × 2.5 mm in which gold was sputtered in a thickness of 100 nm was placed on the back surface, and bonding was performed by heating at 250°C for 3 minutes with pressurization at 5 MPa under a nitrogen atmosphere.

In the evaluation, the shear strength of the obtained bonded body (bonded silicon dummy chip and oxygen-free copper plate) was measured. The bonded body having a shear strength of 10 MPa or more was evaluated as "○", and the bonded body having a shear strength of less than 10 MPa was evaluated as "×".

The shear strength of the obtained bonded body was measured by a method in accordance with JIS Z 3198-7 (Test methods for lead-free solders - Part 7: Methods for shear strength of solder joints on chip components). Specifically, a load was applied to the silicon dummy chip using a tool of a bond tester (SERIES 4000 manufactured by Nordson DAGE Corporation), and the load (maximum shear load) when the silicon dummy chip was peeled off from the copper bonding layer was measured. The moving speed of the tool was 50 μm/sec, and the gap between the tip of the tool and an oxygen-free copper substrate was 50 μm. The obtained maximum shear load was converted into Newtons, and a value obtained by dividing the maximum shear load by the area of the copper bonding layer (2.5 mm × 2.5 mm) was taken as the shear strength (unit: MPa). Seven bonded bodies were produced, and the shear strength was measured for each bonded body. The shear strength used for evaluation of bondability is an average of the shear strengths of the seven bonded bodies.

As illustrated in FIG. 3, in Examples 1 and 2 in which the viscosity change rate $\Delta\eta$ (%) is 20% or less, the evaluation of bondability is O, and it is clear that the bonding paste can be appropriately applied even after a lapse of time. On the other hand, in Comparative Example 1 in which the viscosity change rate $\Delta\eta$ (%) is not 20% or less, the evaluation of bondability is ×, and it is clear that the viscosity increases after a lapse of time, and the bonding paste can be appropriately applied.

Although the embodiments of the present invention have been described above, the embodiments are not limited by the contents of the embodiments. In addition, the aforementioned constituent elements include those that can be easily assumed by those skilled in the art, those that are substantially the same, and those within a so-called equivalent range. Furthermore, the aforementioned constituent elements can be appropriately combined. Furthermore, various omissions, substitutions, or changes in the constituent elements can be made without departing from the gist of the aforementioned embodiments.

Reference Signs List

10    BONDING PASTE

12    COPPER PARTICLES
14    SOLVENT
16    ADDITIVE
20    BONDING LAYER
21    FIRST MEMBER
22    SECOND MEMBER
30    BONDED BODY

**Claims**

1. A bonding paste comprising:

   copper particles;
   a solvent; and
   an additive, wherein
   a viscosity change rate between one day after and thirty days after the bonding paste is produced is 20% or less.

2. The bonding paste according to claim 1, wherein
   the additive is a phosphate ester.

3. The bonding paste according to claim 2, wherein
   the additive has an average molecular weight of 500 or more and 1,400 or less.

4. The bonding paste according to any one of claims 1 to 3, wherein
   the additive has a content of 0.1% or more and 10% or less in terms of a mass ratio with respect to a total of the bonding paste.

**5.** The bonding paste according to any one of claims 1 to 3, wherein
the solvent is a terpineol solvent.

**6.** The bonding paste according to claim 4, wherein
the solvent has an average molecular weight of 100 or more and 200 or less.

**7.** A method for producing a bonded body, the method comprising:
bonding a first member and a second member to each other by using the bonding paste according to any one of claims 1 to 3 as a bonding layer to produce a bonded body.

# FIG.1

# FIG.2

# FIG.3

| | COPPER PARTICLES | SOLVENT | | | ADDITIVE | | | VISCOSITY | | | EVALUATION | |
|---|---|---|---|---|---|---|---|---|---|---|---|---|
| | BET DIAMETER [nm] | TYPE | AVERAGE MOLECULAR WEIGHT | ADDITION AMOUNT [wt%] | TYPE | AVERAGE MOLECULAR WEIGHT | CONTENT [wt%] | ONE DAY $\eta_1$ [Pa·s] | THIRTY DAYS $\eta_{30}$ [Pa·s] | CHANGE RATE $\Delta\eta$ [%] | SHEAR STRENGTH [MPa] | BOND-ABILITY |
| EXAMPLE 1 | 153 | TERPINEOL (DIHYDROTERPINEOL) | 156 | 10 | PHOSPHATE ESTER (POLYOXYETHYLENE TRIDECYL ETHER PHOSPHATE) | 1300 | 2 | 19 | 21 | 10 | 32.1 | ○ |
| EXAMPLE 2 | 153 | TERPINEOL (DIHYDROTERPINEOL) | 156 | 9 | PHOSPHATE ESTER (POLYOXYETHYLENE TRIDECYL ETHER PHOSPHATE) | 1300 | 3 | 30 | 27 | 10 | 26.3 | ○ |
| COMPARATIVE EXAMPLE 1 | 153 | ETHYL HEXANEDIOL | 146 | 11 | PHOSPHATE ESTER (POLYOXYETHYLENE (10) ETHER PHOSPHATE) | 1500 | 1 | 47 | 79 | 68 | 7.6 | × |

Europäisches
Patentamt

European
Patent Office

Office européen
des brevets

## EUROPEAN SEARCH REPORT

**Application Number**

EP 25 15 2395

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 295 975 A1 (MITSUBISHI MATERIALS CORP [JP]) 27 December 2023 (2023-12-27) * claims 1, 6, 12 * * paragraphs [0027], [0028], [0074], [0075] * | 1-7 | INV. B22F1/054 B22F1/0545 B22F1/102 B22F1/107 B22F7/04 |
| X | TANG JIAYU ET AL: "Formulation of a paste for copper thick film", JOURNAL OF NANOPARTICLE RESEARCH, SPRINGER NETHERLANDS, DORDRECHT, vol. 23, no. 8, 1 August 2021 (2021-08-01) , XP037615875, ISSN: 1388-0764, DOI: 10.1007/S11051-021-05300-7 [retrieved on 2021-08-08] | 1,2,4-6 | B23K35/02 B23K35/30 C22C1/04 C22C9/00 H01L23/00 |
| A | * "Preparation of copper paste"; page 2 * | 3,7 | |
| X | JP 5 966370 B2 (MURATA MANUFACTURING CO) 10 August 2016 (2016-08-10) | 1 | |
| A | * paragraphs [0096] - [0101] * * Sample No. 64; table 5 * | 2-7 | |

**TECHNICAL FIELDS SEARCHED (IPC)**

B22F
B23K
C22C

The present search report has been drawn up for all claims

| Place of search | Date of completion of the search | Examiner |
|---|---|---|
| The Hague | 16 May 2025 | Traon, Nicolas |

EPO FORM 1503 03.82 (P04C01)

## ANNEX TO THE EUROPEAN SEARCH REPORT
## ON EUROPEAN PATENT APPLICATION NO.

EP 25 15 2395

This annex lists the patent family members relating to the patent documents cited in the above-mentioned European search report.
The members are as contained in the European Patent Office EDP file on
The European Patent Office is in no way liable for these particulars which are merely given for the purpose of information.

16-05-2025

| Patent document cited in search report | | Publication date | Patent family member(s) | | Publication date |
|---|---|---|---|---|---|
| EP 4295975 | A1 | 27-12-2023 | EP | 4295975 A1 | 27-12-2023 |
| | | | TW | 202302247 A | 16-01-2023 |
| | | | US | 2024321806 A1 | 26-09-2024 |
| | | | WO | 2022176926 A1 | 25-08-2022 |
| JP 5966370 | B2 | 10-08-2016 | JP | 5966370 B2 | 10-08-2016 |
| | | | JP | 2013145699 A | 25-07-2013 |

For more details about this annex : see Official Journal of the European Patent Office, No. 12/82

EPO FORM P0459

**REFERENCES CITED IN THE DESCRIPTION**

**Patent documents cited in the description**

- JP 2020045514 A